# EUROPEAN PATENT SPECIFICATION

(11) **EP 0 433 995 B1**
(45) Date of publication and mention of the grant of the patent: **17.09.1997**
(21) Application number: 90124610.8
(22) Date of filing: 18.12.1990
(51) Int. Cl.: G01R 35/00, G01F 25/00, G01F 23/26, G01R 31/28, G01D 18/00

(54) **Remote instrument testing system**
Testsystem für entfernt gelegene Instrumente
Dispositif de test d'un instrument à distance

(30) Priority: 18.12.1989 US 452697
(43) Date of publication of application: 26.06.1991
(73) Proprietor: DREXELBROOK CONTROLS, INC., Horsham, PA 19044 (US)
(72) Inventor: Maltby, Frederick L., Jenkintown, PA (US); Kramer, Jonathan L., Warminster, PA (US)
(74) Representative: Grünecker, Kinkeldey, Stockmair & Schwanhäusser Anwaltssozietät

(56) References cited:
- GB-A- 2 081 452
- US-A- 4 676 100
- GB-A- 2 081 452
- GB-A- 2 081 452
- US-A- 4 676 100

## Description

### Field of the Invention

This invention relates to an instrument system as indicated in the precharacterizing part of claim.

### Background of the Invention

Instruments are often employed to monitor material conditions or other physical conditions at locations of interest. The output of such an instrument is often communicated electrically from an instrument located near the condition being monitored to a remote location where such output information is desired. In such circumstances, it is often desirable to be able to demonstrate or prove the proper functioning of the system. An example is where the level of materials in a vessel is monitored by a material level monitoring instrument employed so as to be responsive to high level conditions. Such a system is often used to detect or prevent overfilling of the vessel, by appropriate means responsive to the output of the instrument, so as to prevent material waste, personal injury, environmental damage, and other ill effects which may attend overfilling. Such instruments as overfill-responsive instruments are commonly designed so that their output does not change except upon the occurrence of the conditions to which they are designed and calibrated to detect and respond. Since these conditions may be expected to occur only at infrequent intervals, it is highly desirable to be able to determine whether the instrument system will properly respond in the event that such conditions occur.

One way to do so is to adjust the physical condition being monitored to correspond with the condition of interest to which the instrument should respond. In the overfill protection example above, this would require filling the vessel with material to the level at which the instrument is desired to respond, and determining whether the instrument responded properly. This method is often impractical, inconvenient, or otherwise undesirable, for instance where the vessel is large, the material is expensive, or additional material is not available at the time testing is desired. Moreover, this method generally requires at least two people to perform a test, since one is needed to observe the material condition while another observes the instrument output at the generally remote location at which indication or control is to occur.

Instrument systems which permit an operator to calibrate a remote admittance-responsive instrument by imposing calibrating signals on the two wire transmission line carrying the instrument's output are known. Such a system is shown in US-A-4,723,122. However, that system is not adapted to performing instrument testing since it merely varies an internal instrument reference used to calibrate the instrument, and so cannot test the entire instrument system nor be used with an existing instrument system not specifically designed for it. Moreover, it is quite complex in its operation, requiring transmission and reception of encoded signals.

A prior art instrument system as indicated in the precharacterizing part of claim 1 is disclosed in GB-A-2 081 452. This prior art system for determining the level of the contents in a container comprises a capacative a probe as sensor which is disposed insulated in the container and the capacitance of which depends on the level. A measuring transducer acting as the instrument is disposed at the location of the container and produces a measured value signal dependent on the probe capacitance and an evaluation means acting as testing circuit is disposed remote from the container and which is connected to the transducer by a two-wire line via which the DC energy necessary for operating the transducer is transmitted from the evaluation means to the transducer. The measured value signal furnished by the transducer is transmitted to the evaluation means. A switching means is disposed in the transducer for switching from the capacative probe to a test capacitance which is different from any probe capacitance occurring in normal operation and a controller is provided for periodic actuation of the switching means.

It is the object of the invention to provide an instrument testing system which may be used in connection with instrument systems having a wide variety of instrument output signal receiving equipment and in which any failures of the testing system itself will cause an indication of failure, i.e., which will "fail safe".

In accordance with the invention this object is solved by the features as claimed in claim 1.

Other features of the invention will be understood with reference to the following specification and drawings.

### Brief Description of the Drawings

Figure 1 is a block diagram showing an instrument testing system in accordance with the prior art.

Figure 2 is a block diagram showing an instrument testing system in accordance with the present invention.

Figure 3 is a more detailed functional diagram showing an instrument testing system in accordance with the present invention without the controller of the present invention, in connection with an admittance-responsive, current output instrument system.

Figure 4 is a schematic diagram of the preferred embodiment of the testing circuit of the present invention without the controller of the present invention.

### Detailed Description of the Preferred Embodiment

As used herein, "instrument system" refers to a system for providing a desired output in response to a monitored condition of interest, including primary condition-responsive elements, all means for transmitting, receiving, or operating upon signals responsive to the condition of interest, and all ancillary functional elements involved in normal operation of the system. As used herein, "instrument testing system" refers to a system for testing an instrument system to evaluate its likely response to a monitored condition of interest.

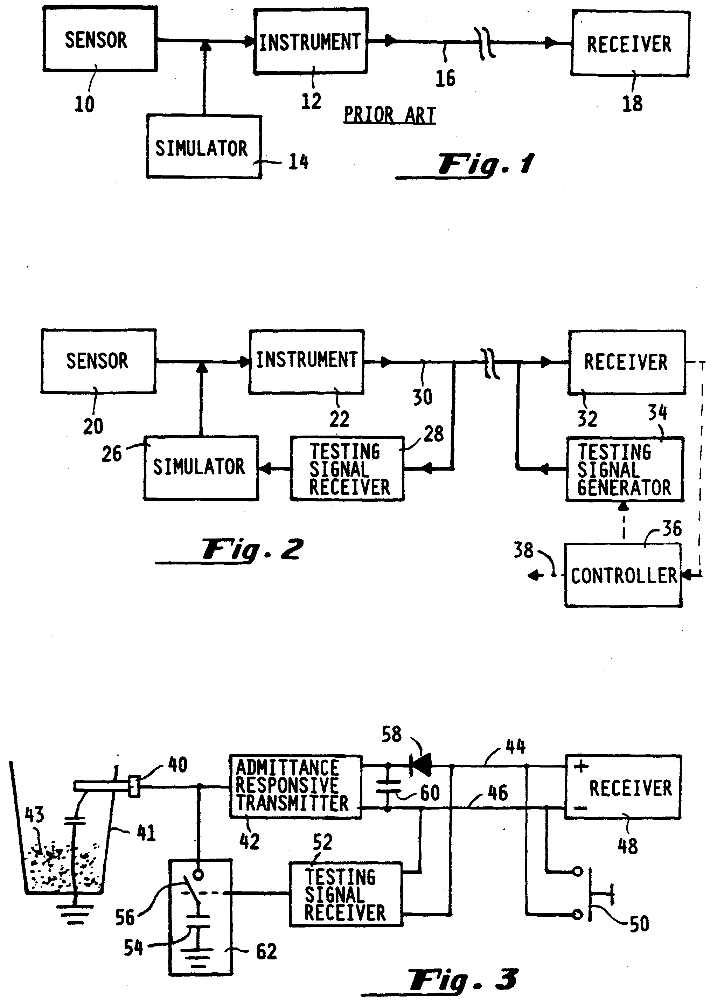

Figure 1 shows a system for testing an instrument in accordance with the prior art. The instrument system to be tested includes a sensor or primary element 10 which provides an output responsive to a physical condition of interest. An instrument 12 is coupled to sensor 10 and provides an output responsive to the output of sensor 10 corresponding to monitored conditions of interest. Instrument 12 must generally be located near the condition being monitored. Instrument 12 provides an output which is coupled via communication channel 16 to a receiver 18, which may be remotely located and which may provide a variety of alarm, data logging, control, and other functions in response to the instrument output received over communication channel 16.

In accordance with the prior art, the instrument system of Figure 1 may be tested by providing a simulation circuit 14 coupled to the instrument system for simulating, in the instrument, conditions corresponding to monitored conditions of interest. When such conditions are simulated, if the instrument system is functioning properly, then an output signal corresponding to the monitored condition of interest will be present in communication channel 16, which will cause receiver 18 to assume a predetermined corresponding state. While such instrument testing systems may be effective for testing the operational status of the instrument system, or at least a substantial portion thereof, in practice they have several drawbacks. Generally, the simulator 14 must be located in the vicinity of instrument 12, whereas the receiver 18 may be remotely located. One way to accommodate such separation has been to use two persons in communication with each other to perform the testing function, one of whom is located at simulator 14 for actuating it and the other of whom is located at receiver 18 for monitoring its state. This method is inconvenient and expensive, and may in fact introduce errors into the testing process caused by radio frequency interference during radio communication between the operators. Moreover, it may be dangerous or inconvenient for an operator to actuate a simulator 14 in the vicinity of the instrument 12. An alternative method of accommodating the separation between signal simulating circuitry and the location of the output of interest has been to provide a separate communication channel between such locations so that a single operator may both cause a simulation signal to be applied to the instrument and observe the system output. However, provision of such additional communications channels is generally expensive, particularly when the instrument is required to be intrinsically safe.

Figure 2 shows a block diagram of an instrument system in accordance with the present invention which permits instrument testing while avoiding the aforementioned drawbacks of the prior art. The system of Figure 2 includes an instrument system comprising a sensor or primary element 20 which is responsive to a condition of interest, an instrument 22 which is coupled to sensor 20 and is responsive to the output of sensor 20 corresponding to monitored conditions of interest, a communication channel 30 for conveying output signals from instrument 22 to a remote location, and a receiver 32 which may be remotely located from instrument 22 and is coupled to communication channel 30. Typically, communication channel 30 will comprise a current loop, such as a 4-20 mA current loop. Receiver 32 comprises functional elements responsive to the instrument output signal present in communication channel 30, and may include indicators, display devices, data logging devices, signal processing or transmission devices, control devices, and the like. Receiver 32 may further comprise ancillary functional elements such as power supplies and intrinsic safety protection devices for use in two-wire D.C. current loop systems. The testing system of Figure 2 includes simulator 26 for simulating sensor signals corresponding to monitored conditions of interest. Such simulating signals are desirably applied to the instrument system functionally as close as possible to the monitored condition of interest in order to test operation of as much of the instrument system as is possible.

Unlike the prior art system of Figure 1, the system of Figure 2 includes a testing signal receiver 28 coupled to communication channel 30 and to simulator 26 for receiving testing signals from communication channel 30 and actuating simulator 26 in response thereto. The instrument testing system further includes testing signal generator 34 for applying testing signals to communication channel 30 to initiate a test of the instrument system. Testing signal generating means 34 may be located remote from instrument 22, including in the vicinity of receiver 32. Accordingly, a single operator stationed in the vicinity of receiver 32 may test the functionality of substantially the entire instrument system by applying to communication channel 30 a testing signal, and verifying that the appropriate instrument output signal state in communication channel 30 and/or corresponding state of receiver 32 occurs.

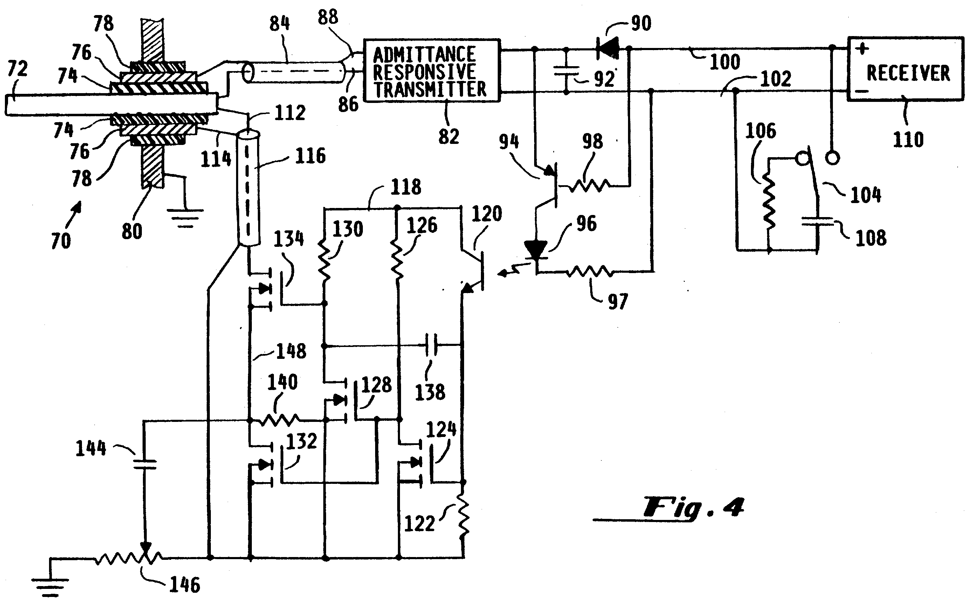

The testing function of the system of the invention may be automated, for instance so that the generation of testing signals and verification of proper response is made to occur automatically and periodically. Figure 2 shows a controller 36 which may be coupled to testing signal generator 34 and to receiver 32 as shown to integrate the functions of transmitting a testing signal and determination of whether a system response indicative of proper operation has occurred. Controller 36 causes generator 34 to transmit a testing signal upon the occurrence of predetermined conditions, such as at periodic intervals or at predetermined times. Controller 36 receives an input from the system which in normal operation is responsive to conditions of interest. As shown, the input of controller 36 is derived from receiver 32, but it may also be taken directly from communication channel 30. Controller 36 determines whether the system has properly responded to tests it has initiated, and may provide an output 38 reflecting the results of such determinations. Controller 36 may be embodied in a dedicated controller, a function in a process computer, or the like. While shown only in Figure 2, it will be understood that such a controller also has to be used in connection with the more detailed systems shown in Figures 3 and 4.

By use of communication channel 30 both for transmitting output information from instrument 22 and for transmitting testing signals to the instrument to initiate testing, considerable savings and efficiencies may be obtained.

Figure 3 shows a more detailed functional diagram of an instrument testing system used in connection with an instrument system in which the instrument is an admittance-responsive transmitter producing a current output signal.

In Figure 3, the instrument system includes admittance-responsive sensor 40 which is mounted in a vessel 41 containing the material 43 to be monitored. Sensor 40 produces as its output an admittance, depicted in the drawing and typically occurring as a capacitance, which is a function of and varies in response to variations in the monitored condition. Systems in which a monitored condition such as material level, composition, proximity, and the like produce a variable admittance of a sensor are well known in the art. The instrument in Figure 3 is an admittance-responsive transmitter 42, having an input coupled to sensor 40, which produces as an output a current signal in a loop including signal wires 44 and 46, which current signal is a function of the admittance coupled to the input of the transmitter. The instrument system of Figure 3 further includes receiver 48 coupled to signal wires 44 and 46 for producing an output responsive to the current in the signal wires. As has been discussed, receiver 48 may perform indication, display, data logging, signal processing, signal transmission, control and other functions in response to the current signal in signal wires 44 and 46, which wires form a communication channel between transmitter 42 and receiver 48. Transmitter 42 may be a two-wire transmitter, i.e. one which receives its power over a pair of conductors which also serve as the communication channel for its output signal.

Admittance responsive, current transmitting instrument systems are well known in the art. Examples of such systems are shown in US-A-4,146,834, in which the output is a current signal proportional to sensor admittance, and US-A-4,363,030, in which the transmitter output is a bistable current signal for on-off indication, control, or the like. In such two-wire systems, receiver 48 may comprise a power supply for energizing and providing power to transmitter 42 via signal wires 44 and 46.

A simulator circuit 62 is provided comprising a switch 56 and an admittance element 54, depicted as a capacitance. Switch 56 is controlled by a testing signal receiver 52. When switch 56 is closed, the admittance of capacitor 54 is coupled to the admittance-responsive input of the transmitter 42, thereby placing it in parallel with the admittance of sensor 40. Such a system is suitable, for instance, in an overfill protection system wherein occurrence of the material condition of interest, namely a high material level, may cover an admittance sensor disposed at the level of interest in a vessel and thereby increase its admittance. The admittance of element 54 may be selected, or made adjustable, so as to correspond with the expected increase in admittance upon occurrence of the material condition of interest, thereby simulating as closely as possible the effects of such a condition. It will be understood, of course, that in situations where the occurrence of the material condition of interest results in a lowering of the admittance of the sensor 40, switch 56 may be made to be normally closed, becoming opened under control of testing signal receiver 52 to decouple admittance element 54 from the admittance responsive input of transmitter 42, thereby simulating the material condition of interest by lowering the admittance presented thereto.

In the system of Figure 3, transition of switch 56 to effect system testing may be remotely effected at any point along signal wires 44 and 46, such as in the vicinity of receiver 48. A testing signal generator comprising momentary switch 50 temporarily provides, when actuated, a low impedance between signal wires 44 and 46. Such signal wires will typically have a potential across them in a range of 10 to 30 volts. Actuation of switch 50 causes a negative voltage transient pulse to be imposed between the signal wires. This transient forms, in the system of Figure 3, a testing signal. Testing signal receiver 52, generally located in the vicinity of transmitter 42, detects negative voltage transients across the signal wires 44 and 46 and actuates switch 56 upon the occurrence thereof. Accordingly, in the system of Figure 3, an operator may test substantially the entire system from the vicinity of receiver 48 by actuating switch 50. After actuation of switch 50, if the operator observes an output of receiver 48 and/or a current signal in signal wires 44 and 46 which corresponds to the output expected upon occurrence of the conditions simulated by the simulation circuitry, and if such output is observed within the time interval after actuation corresponding to the system response time, then it may reasonably be concluded that the transmitter 42, the signal wires, 44 and 46 and the receiver 48, as well as the testing signal generator 50, testing signal receiver 52, and simulator 62 are properly functional.

Diode 58 and capacitor 60 are provided at the input of admittance-responsive transmitter 42 to permit it to continue operation during intervals when the input voltage across the signal wires 44 and 46 is insufficient to operate the transmitter. This may occur, for instance, when switch 50 is actuated. In such circumstances, charge stored in capacitor 60 permits continued operation of transmitter 42, and diode 58 prevents discharge of capacitor 60 in response to closure of switch 50. Other energy storage devices such as a battery might be used in place of capacitor 60.

Because the testing system of the invention utilizes the communication channel for transmitting both instrument output and testing signals, however, measures must be taken to ensure that a proper system response is detected and that initiation of a test does not itself cause an erroneous response. In particular, when a voltage transient is used as a testing signal in a current loop, problems may arise if the simulating signal is applied to the instrument only during the time that the testing signal is applied. In such a situation, the instrument output responsive to the simulation would occur when it was unable to be detected due to the presence of the testing signal. Accordingly, in the system of Figure 3, the simulator 62 applies the simulating signal for an extended period of time after receipt of a testing signal so that the system output may be detected after the cessation of the testing signal. Times on the order of 2 to 10 seconds may be appropriate if the system response is to be observed by a person, but shorter times may be acceptable if the system output is to be detected by an electronic device such as a controller, and longer times may be required for instance if the instrument 22 or receiver 32 has a time delay function built in or an extended response time. Another problem which may arise with use of voltage testing signals in a current loop is spurious response of the receiver to the voltage signals. By ensuring that the sensor-simulating signal is present after the testing signal, a true receiver response to the instrument output may be obtained.

Figure 4 shows a schematic diagram of the preferred embodiment of the invention. In the embodiment of Figure 4, sensor 70 is of the type which includes a tubular "guard" or "shield" electrode 76, which is interposed between a measuring electrode 72 and grounded vessel wall 80 so as to eliminate stray admittances between them. Shield electrode 76 is isolated from measuring electrode 72 and grounded vessel wall 80 by tubular insulating members 74 and 78, respectively. Such sensors are well known in the art and are disclosed, for instance, in U. S. Patent No. 3,879,644, assigned to the assignee of this invention. Measuring electrode 72 is coupled to an admittance-responsive input of an admittance-responsive transmitter 82 by conductor 86. As shown, conductor 86 may comprise the center wire of a coaxial cable 84, the outer conductor 88 of which is coupled at the sensor 70 to shield electrode 76 and at transmitter 82 to a source of potential substantially equal to that of conductor 86. Such use of a guard potential enables a substantial reduction in detection of stray admittances associated with the measurement.

Admittance-responsive transmitter 82 is coupled by signal wires 100, 102 to a receiver 110 which may be remotely located and which may include such receiver functions as have been previously described. Transmitter 82 is desirably a two-wire transmitter, in which event receiver 110 would include a power supply for energizing the signal wires 100, 102.

A testing signal generator is provided comprising switch 104, capacitor 108 and resistor 106. When switch 104 is in the position shown, capacitor 108 is discharged by resistor 106. When switch 104 is transferred to the other position, capacitor 108 will induce a negative transient voltage pulse in the potential across the signal wires. Such a transient is utilized in the Figure 4 embodiment as a testing signal. It will be understood that other means for generating such a transient voltage pulse may be used, such as actuation of a transistor coupled to the signal wires. However, the embodiment shown has the virtues of simplicity, reliability, and inexpensiveness.

The testing signal is received by a testing signal receiver comprising transistor 94, resistors 97 and 98, and LED 96, the latter of which comprises the input of an optical isolator, the output element of which is phototransistor 120. As in the Figure 3 embodiment, diode 90 and capacitor 92 permit transmitter 82 to continue operation despite transients imposed on the signal wires by the testing signal generator.

A negative transient on signal wire 100 provides base current for transistor 94 through resistor 98. This causes a collector current transient in transistor 94 and in LED 96, which current is limited by resistor 97. This state corresponds to detection of a testing signal.

The remainder of the circuitry in Figure 4 comprises a simulator circuit for applying an admittance signal to the sensor upon detection of a testing signal. This simulator is coupled by a coaxial cable 116 to the sensing element 70. Central conductor 112 is coupled to the admittance measuring electrode 72 at one end and to an admittance switching network, to be more fully described below, at the other end. The outer conductor 114 of coaxial cable 116 couples guard potential from the sensor to the simulator, and shields conductor 112.

Conductor 118 is coupled to a guard-referenced DC source for operating the simulator circuit, which source for clarity is not shown. A current pulse in LED 96 caused by a testing signal will in turn cause a current pulse in phototransistor 120, thereby actuating a one-shot or monostable multivibrator comprising transistors 124 and 128, load resistors 122, 126, and 130, and a feedback capacitor 138. Prior to simulator circuit actuation, resistor 122 biases transistor 124 off and resistor 126 biases transistor 128 on. This causes admittance switching transistor 134 to be off and transistor 132 to be on, thus coupling conductor 148 to shield potential and preventing the simulator circuit from coupling an admittance to sensor 70. In this circuit state, capacitor 138 is discharged.

Conduction in phototransistor 120, in response to receipt of a testing signal, causes transistor 124 to turn on which in turn causes transistor 128 to turn off. In response, transistor 132 is turned off and transistor 134 is turned on, coupling the admittance of conductor 148 to the sensor via conductor 112. The admittance of conductor 148 is adjustable from zero to the admittance of capacitor 144 by means of adjustment of potentiometer 146, which permits adjustment to correspond to a predetermined material condition.

After the current transients in LED 96 and phototransistor 120 have decayed, capacitor 138 is discharged through resistor 122. When capacitor 138 has been sufficiently discharged that the gate voltage of transistor 124 reaches its threshold voltage, transistor 124 turns off and the circuit reverts to its state prior to actuation. Thus, a testing signal causes an effective admittance value to be coupled to measuring electrode 72 of sensor 70 for a predetermined time after a testing signal occurs. The added admittance is chosen so as to be greater than required for actuation of admittance responsive transmitter 82. Accordingly, within the time during which the simulating admittance is added, receiver 110 will indicate a high level output only if the entire system is functional.

It will be noted that the simulator circuit is coupled through conductor 116 to the sensor rather than directly to the instrument and that cables 116 and 84 are separately connected to sensor 70. This ensures that failure of a cable or a connection will either immediately cause an alarm output, or will cause the system to be unable to properly respond to a testing signal.

It is therefore seen that a system has been disclosed for remotely testing an instrument system in accordance with the objects set forth above. Variations on the systems described will no doubt occur to those of ordinary skill in the art. Accordingly, the invention as defined by the appended claims is not to be limited to the specific embodiments shown.

## Claims

1. An instrument system comprising:
a sensor (20;40;70) having an output which is responsive to physical conditions;
an instrument (22;42;82) having an input coupled to the output of said sensor (20;40;70) and an output adapted to be coupled to a communication channel (30);
a testing circuit (26,28;52,62) having an input coupled to the output of said instrument (22; 42; 82) and thereby also adapted to be coupled to said communication channel (30) and an output, said testing circuit producing a predetermined output signal in response to a predetermined signal at the input of said testing circuit;
a testing signal generator (34) having an output adapted to be coupled to said communication channel (30) and producing an output signal corresponding to said predetermined testing circuit input signal; and
a controller (36) coupled to said testing signal generator (34) for causing generation of testing signals by said testing signal generator (34) under predetermined conditions,
**characterized in that**
said controller (36) is responsive to signals produced at said instrument output when said instrument output (22;42;82) and said testing signal generator (34) are coupled to said communication channel (30) and in that the output of said testing circuit (26,28;52,62) is coupled to the output of said sensor (20;40;70).

2. An instrument system according to claim 1, wherein said controller provides an output (38) indicating whether the system has properly responded to signals generated by said testing signal generator (34).

3. An instrument system according to claim 1, further comprising a receiver (32) coupled to said communication channel (30) to generate a receiver output which is responsive to signals produced at said instrument output when said instrument (22;42;82) and said receiver (32) are coupled to said communication channel (30), wherein said controller (36) is responsive to said output of said receiver (32).

4. An instrument system according to claim 1, wherein said controller (36) causes said testing signal generator (34) to produce said output signals at periodic intervals.

5. An instrument system according to claim 1, wherein said testing circuit (26,28;52,62) produces said predetermined output signal for a predetermined time in response to said predetermined signal at the input of said testing circuit (26,28;52,62), and said controller (36) responds to signals produced at said instrument output during said predetermined time in order to provide an output (38) indicating whether the system has properly responded to signals generated by said testing signal generator (34).

6. An instrument system according to claim 1, wherein the output of said instrument (42;82) comprises two wires (44,46;100,102) for a current output signal.

7. An instrument system according to claim 6, wherein said predetermined testing circuit input signal is a voltage pulse.

8. An instrument system according to any one of the foregoing claims, wherein said sensor (40;70) is admittance-responsive and has an admittance output which is responsive to said physical conditions;
said instrument (42;82) has an admittance-responsive input coupled to the output of said sensor (40;70) and includes a guard voltage source at substantially the same potential as said admittance-responsive input;
said testing circuit (52,62) includes an admittance element (54;144) and a switch (56;134) for coupling said admittance element (54;144) to said admittance responsive instrument input in response to a predetermined signal at the input of said testing circuit, wherein the one electrode of said switch (56;134) connected with said admittance element (54;144) is coupled to said guard voltage source when said admittance element (54;144) is not coupled to said admittance responsive instrument input.

9. An instrument system according to claim 8, wherein said testing circuit (52,62)produces, when coupled to said admittance responsive instrument input, an admittance output signal which simulates the admittance output of said sensor (40;70) under predetermined physical conditions.

## Patentansprüche

1. Instrumentensystem mit:
einem Sensor (20; 40; 70), der einen auf physikalische Bedingungen ansprechenden Ausgang hat;
einem Instrument (22; 42; 82), das einen mit dem Ausgang des Sensors (20; 40; 70) gekoppelten Eingang sowie einen mit einem Übertragungskanal (30) koppelbaren Ausgang hat;
einer Prüfschaltung (26, 28; 52, 62), die einen mit dem Ausgang des Instruments (22; 42; 82) gekoppelten Eingang sowie einen mit dem Übertragungskanal (30) koppelbaren Ausgang hat, wobei die Prüfschaltung ein vorbestimmtes Ausgangssignal im Ansprechen auf ein vorbestimmtes Signal am Eingang der Prüfschaltung erzeugt;
einem Prüfsignalgenerator (34), der einen mit dem Übertragungskanal (30) koppelbaren Ausgang hat und ein dem vorbestimmten Eingangssignal der Prüfschaltung entsprechendes Ausgangssignal erzeugt, und
einer Steuereinrichtung (36), die mit dem Prüfsignalgenerator (34) gekoppelt ist, um die Erzeugung von Prüfsignalen durch den Prüfsignalgenerator (34) unter vorbestimmten Bedingungen zu bewirken;
**dadurch gekennzeichnet**, daß die Steuereinrichtung (36) auf an dem
Instrumentenausgang erzeugte Signale anspricht, wenn der Instrumentenausgang (22; 42; 82) und der Prüfsignalgenerator (34) mit dem Übertragungskanal (30) gekoppelt sind, und
der Ausgang der Prüfschaltung (26, 28; 52, 62) mit dem Ausgang des Sensors (20; 40; 70) gekoppelt ist.

2. Instrumengensystem nach Anspruch 1, wobei die Steuereinrichtung ein Ausgangssignal (38) erzeugt, das angibt, ob das System auf von dem Prüfsignalgenerator (34) erzeugte Signale geeignet angesprochen hat.

3. Instrumentensystem nach Anspruch 1, das weiterhin aufweist, einen mit dem Übertragungskanal (30) gekoppelten Empfänger (32) zum Erzeugen eines Empfängerausgangssignals, das auf Signale anspricht, die an dem Instrumentenausgang erzeugt werden, wenn das Instrument (22; 42; 82) und der Empfänger (32) mit dem Übertragungskanal (30) gekoppelt sind, wobei die Steuereinrichtung (36) auf das Ausgangssignal des Empfängers (32) anspricht.

4. Instrumentensystem nach Anspruch 1, wobei die Steuereinrichtung (36) den Prüfsignalgenerator (34) dazu veranlaßt, die Ausgangssignale mit periodischen Intervallen zu erzeugen.

5. Instrumentensystem nach Anspruch 1, wobei die Prüfschaltung (26, 28; 52, 62) das vorbestimmte Ausgangssignal für eine vorbestimmte Zeit im Ansprechen auf das vorbestimmte Signal an dem Eingang der Prüfschaltung (26, 28; 52, 62) erzeugt, und die Steuereinrichtung (36) auf Signale anspricht, die an dem Instrumentenausgang während der vorbestimmten Zeit erzeugt werden, um ein Ausgangssignal (38) zu erzeugen, das angibt, ob das System auf von dem Prüfsignalgenerator (34) erzeugte Signale geeignet angesprochen hat.

6. Instrumentensystem nach Anspruch 1, wobei der Ausgang des Instruments (42; 82) zwei Adern (44, 46; 100, 102) für einen Ausgangsstrom aufweist.

7. Instrumentensystem nach Anspruch 6, wobei das vorbestimmte Eingangssignal für die Prüfschaltung ein Spannungsimpuls ist.

8. Instrumentensystem nach einem der vorhergehenden Ansprüche, wobei der Sensor (40; 70) scheinleitwertempfindlich ist und einen auf die physikalischen Bedingungen ansprechenden Scheinleitwertausgang hat;
das Instrument (42; 82) einen mit dem Ausgang des Sensors (40; 70) gekoppelten scheinleitwertempfindlichen Eingang hat und eine Führungsspannungsquelle umfaßt, die im wesentlichen das gleiche Potential wie der scheinleitwertabhängige Eingang hat;
die Prüfschaltung (52, 62) ein Scheinleitwertelement (54; 144) und einen Schalter (56; 134) zum Koppeln des Scheinleitwertelements (54; 144) an den scheinleitwertempfindlichen Instrumenteneingang im Ansprechen auf ein vorbestimmtes Signal an dem Eingang der Prüfschaltung umfaßt, wobei die eine Elektrode des Schalters (56; 134) mit dem Scheinleitwertelement (54; 144) verbunden ist und mit der Führungsspannungsquelle gekoppelt ist, wenn das Scheinleitwertelement (54; 144) nicht mit dem scheinleitwertempfindlichen Instrumenteneingang gekoppelt ist.

9. Instrumentensystem nach Anspruch 8, wobei die Prüfschaltung (52, 62), wenn sie mit dem scheinleitwertempfindlichen Instrumenteneingang gekoppelt ist, ein Scheinleitwert-Ausgangssignal erzeugt, das den Scheinleitwertausgang des Sensors (40; 70) unter vorbestimmten physikalischen Bedingungen simuliert.

## Revendications

1. Système à instrument comprenant :
un capteur (20;40;70) possédant une sortie, qui est apte à répondre à des conditions physiques;
un instrument (22;42;82) possédant une entrée couplée à la sortie dudit capteur (20;40;70) et une sortie adaptée de manière à être couplée à un canal de communication (30);
un circuit de test (26,28;52,62) possédant une entrée couplée à la sortie dudit instrument (22;42;82) et de ce fait également adaptée pour être couplée audit canal de communication (30), et une sortie, ledit circuit de test produisant un signal de sortie prédéterminé en réponse à un signal prédéterminé appliqué à l'entrée dudit circuit de test;
un générateur (34) de signaux de test comportant une sortie adaptée pour être couplée audit canal de communication (30) et produisant un signal de sortie correspondant audit signal d'entrée du circuit de test prédéterminé; et
un dispositif de commande (36) couplé audit générateur (34) de signaux de test pour provoquer la production de signaux de test par ledit générateur (34) de signaux de test dans des conditions prédéterminées,
caractérisé en ce que
ledit dispositif de commande (36) est apte à répondre à des signaux produits sur ladite sortie de l'instrument lorsque ladite sortie de l'instrument (22;42;82) et ledit générateur (34) de signaux de test sont couplés audit canal de communication (30), et en ce que la sortie dudit circuit de test (26,28;52,62) est couplée à la sortie dudit capteur (20;40;70).

2. Système à instrument selon la revendication 1, dans lequel ledit dispositif de commande produit un signal de sortie (38) indiquant si le système a correctement répondu à des signaux produits par ledit générateur (34) de signaux de test.

3. Système à instrument selon la revendication 1, comprenant en outre un récepteur (32) couplé audit canal de communication (30) pour produire un signal de sortie du récepteur, qui est apte à répondre à des signaux produits sur ladite sortie de l'instrument lorsque ledit instrument (22;42;82) et ledit récepteur (32) sont couplés audit canal de communication (30), ledit dispositif de commande (36) étant apte à répondre audit signal de sortie dudit récepteur (32).

4. Système à instrument selon la revendication 1, dans lequel ledit dispositif de commande (36) amène ledit générateur (34) de signaux de test à produire lesdits signaux de sortie à des intervalles périodiques.

5. Système à instrument selon la revendication 1, dans lequel ledit circuit de test (26,28;52,62) produit ledit signal de sortie prédéterminé pendant un intervalle de temps prédéterminé en réponse audit signal prédéterminé présent à l'entrée dudit circuit de test (26,28;52,62), et ledit dispositif de commande (36) répond à des signaux produits sur ladite sortie de l'instrument pendant ledit intervalle de temps prédéterminé pour produire un signal de sortie (38) indiquant si le système a répondu correctement des signaux produits par ledit générateur (34) de signaux de test.

6. Système à instrument selon la revendication 1, dans lequel la sortie dudit instrument (42;82) comprend deux fils (44,46;100,102) pour un signal de sortie de courant.

7. Système à instrument selon la revendication 6, dans lequel ledit signal d'entrée du circuit de test prédéterminé est une impulsion de tension.

8. Système à instrument selon l'une quelconque des revendications précédentes, dans lequel ledit capteur (40;70) est sensible à une admittance et possède une sortie d'admittance, qui est apte à répondre auxdites conditions physiques;
ledit instrument (42;82) possède une entrée sensible à l'admittance et couplée à la sortie dudit capteur (40;70) et comprend une source de tension de garde située essentiellement au même potentiel que ladite entrée apte à répondre à l'admittance;
ledit circuit de test (52,62) comprend un élément d'admittance (54;144) et un commutateur (56;134) pour coupler ledit élément d'admittance (54;144) à ladite entrée de l'instrument apte à répondre à l'admittance, en réponse à un signal prédéterminé appliqué à l'entrée dudit circuit de test, une électrode dudit commutateur (56;134) connectée audit élément d'admittance (54;144) étant couplée à ladite source de tension de garde lorsque ledit élément d'admittance (54;144) n'est pas couplé à ladite entrée de l'instrument apte à répondre à l'admittance.

9. Système à instrument selon la revendication 8, dans lequel ledit circuit de test (52,62) produit, lorsqu'il est couplé à ladite entrée d'instrument apte à répondre à l'admittance, un signal de sortie de l'admittance qui simule le signal de sortie de l'admittance dudit capteur (40;70) dans des conditions physiques prédéterminées.
